# EUROPEAN PATENT APPLICATION

(11) **EP 4 506 753 A2**
(43) Date of publication of application: **12.02.2025**
(21) Application number: 24192825.8
(22) Date of filing: 05.08.2024
(51) Int. Cl.: G03F 7/022, C08G 69/02, G03F 7/023

(54) **PHOTOSENSITIVE COMPOSITION**

(30) Priority: 03.08.2023 KR 20230101738; 03.08.2024 KR 20240103520
(71) Applicant: Duksan Neolux Co., Ltd, Cheonan-si, Chungcheongnam-do (KR)
(72) Inventor: CHUNG, Yeon Joon, Cheonan-si, Chungcheongnam-do (KR); SONG, Gwang Sik, Cheonan-si, Chungcheongnam-do (KR); LEE, Changmin, Cheonan-si, Chungcheongnam-do (KR); KIM, Kyung Soo, Cheonan-si, Chungcheongnam-do (KR)
(74) Representative: BCKIP Part mbB

(57) **Abstract**

The present disclosure relates to a polymer and a positive photosensitive composition which have increased mechanical properties, a cured film, a protective film, an insulating film, and a semiconductor device which are manufactured therefrom; and a method of synthesizing a polymer and a method for producing a positive photosensitive composition, for providing a display device.

## Description

### BACKGROUND

### Field

The present disclosure relates to a method for producing a polymer using only γ-butyrolactone as a single solvent and a positive photosensitive composition used in a semiconductor device or display device manufactured using the same.

### Related Art

A photolithography process largely consists in the order of a coating step of applying a photoresist composition to a substrate, an exposure step of forming a pattern on a photoresist film using a light source or E-beam that passes through a mask, and a development step of removing a specific area of the photoresist film with a pattern engraved on it, and is performed by adding a heat treatment (baking) step of removing a solvent from the photoresist composition or hardening the film in the middle of each step.

The photolithography process is largely divided into negative and positive processes, and may be divided into, in the development step, a positive process in which the exposed part chemically reacts with a developer and its reaction product is dissolved and removed and a negative process in which the non-exposed part contrary to the positive process chemically reacts with the developer and its reaction product is dissolved and removed. Since the positive process of those uses a photosensitizer (photo active compound) that absorbs light and increases solubility in the exposure step, allowing only the exposed part to be accurately removed in the development step, a more precise and accurate pattern may be obtained compared to the negative process.

In conventional positive photosensitive resin compositions used in semiconductor devices and display devices, resins such as polyimide, polybenzoxazole, *etc.* are used due to their high heat resistance, chemical resistance, and weather resistance. However, since the molecular weight of the polymer resin used for implementation of precise circuits is limited by performing development with an alkaline aqueous solution in the development step, the mechanical properties that can be realized show limitation, and N-methylpyrrolidone, which is generally used in synthesis, has the hazards to the environment and the human body.

### (Prior Art Documents)

### (Patent Documents)

(Patent Document 1) Korean Patent Publication No. 2015-0037400
(Patent Document 2) Korean Patent Publication No. 2022-0143710

### SUMMARY

The present disclosure is intended to solve the hazards to the environment and the human body by synthesizing the polymers of the synthesis examples and embodiments below using only γ-butyrolactone in order to solve the problems of the prior art.

Another embodiment is to increase tensile strength and elongation by reducing unreacted monomers so as to increase mechanical properties of polymer components.

Another embodiment is to provide a positive photosensitive composition using the polymer.

A polymer according to the present disclosure is preferably produced using γ-butyrolactone as a single solvent by including the following Formula 1-1; Formula 1-2; Formula 1-3; Formula 1-4; or combinations thereof.

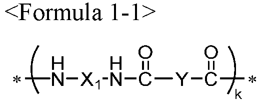

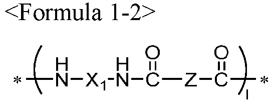

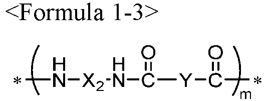

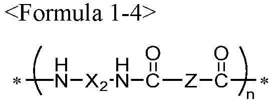

In Formula 1-1; Formula 1-2; Formula 1-3; and Formula 1-4 above,
1) * is a part where the bonds are connected as repeating units,
2) * at the end of the polymer is a part where Formulas Q-1 to Q-10 are bonded by an amide bond or imide bond,
3) X₁ or X₂ is Formula 2 below,
4) Y is selected from the group consisting of: a C₆ to C₃₀ arylene group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkylene group; a C₁ to C₂₀ cycloalkylene group; a C₂ to C₂₀ alkenylene group; a C₃ to C₂₀ cycloalkenylene group; a C₂ to C₂₀ alkynylene group; a C₃ to C₂₀ cycloalkynylene group; Formula 2; or combinations thereof,
5) Z is selected from the group consisting of: a C₆ to C₃₀ arylene group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkylene group; a C₁ to C₂₀ cycloalkylene group; a C₂ to C₂₀ alkenylene group; a C₃ to C₂₀ cycloalkenylene group; a C₂ to C₂₀ alkynylene group; a C₃ to C₂₀ cycloalkynylene group; Formula 3; or combinations thereof,
6) k, l, m, and n are integers of 1 or more, 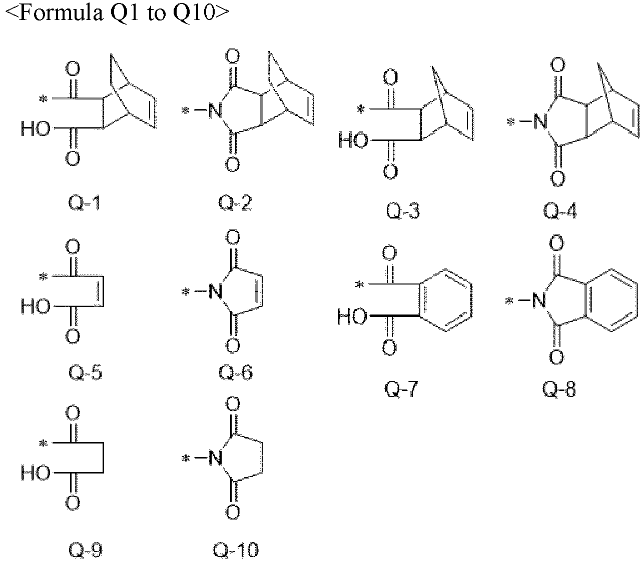
7) The polymer terminal is one in which a formula selected from the group consisting of one selected from the Formulas Q-1 to Q-10 above or combinations thereof is bonded by an amide or imide bond,

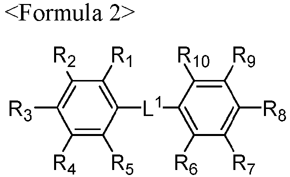

In Formula 2,
8) L¹ is selected from the group consisting of a single bond, -CH₂-, -CH₂CH₂-,-CH₂OCH₂-, -CH(CH₃)-, -C(CH₃)₂-, -C(C₂H₅)₂-, -C(C₃H₇)₂-, -C(C₄H₉)₂-, -C(C₅H₁₁)₂-, -C(C₆H₁₃)₂-, -C(C₅H₁₀)-, -O-, -CH(CF₃)-, -C(CF₃)₂-, -S-, -SO₂-, Si(CH₃)₂-, -C₆H₄-, -CO-, -NHCO-, and -COO-,
9) Two of R₁ to R₁₀ are connection sites with amide groups of Formulas 1-1 and 1-2,
10) Residual R₁ to R₁₀ except for the above connection sites are each independently hydrogen; heavy hydrogen; a hydroxyl group; an C₆ to C₃₀ aryl group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkyl group; a C₂ to C₂₀ alkenyl group; a C₂ to C₂₀ alkyne group; a C₁ to C₂₀ alkoxy group; a C₆ to C₃₀ aryloxy group; a fluorenyl group; a carbonyl group; an ether group; a carboxyl group; or a C₁ to C₂₀ alkoxycarbonyl group,
11) When L¹ is a single bond, adjacent R₁ and R₁₀ which are not the connection sites; and R₅ and R₆ may form a ring,

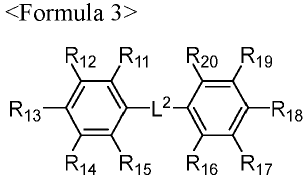

In Formula 3,
12) L² is selected from the group consisting of a single bond, -CH₂-, -CH₂CH₂-,-CH₂OCH₂-, -CH(CH₃)-, -C(CH₃)₂-, -C(C₂H₅)₂-, -C(C₃H₇)₂-, -C(C₄H₉)₂-, -C(C₅H₁₁)₂-, -C(C₆H₁₃)₂-, -C(C₅H₁₀)-, -O-, -CH(CF₃)-, -C(CF₃)₂-, -S-, -SO₂-, Si(CH₃)₂-, -C₆H₄-, -CO-, -NHCO-, and -COO-,
13) Two of Rn to R₂₀ are connection sites with amide groups of Formulas 1-1 and 1-2,
14) Residual R₁₁ to R₂₀ except for the above connection sites are each independently hydrogen; heavy hydrogen; a hydroxyl group; an C₆ to C₃₀ aryl group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkyl group; a C₂ to C₂₀ alkenyl group; a C₂ to C₂₀ alkyne group; a C₁ to C₂₀ alkoxy group; a C₆ to C₃₀ aryloxy group; a fluorenyl group; a carbonyl group; an ether group; a carboxyl group; or a C₁ to C₂₀ alkoxycarbonyl group, and provided that two of residual R₁₁ to R₂₀ except for the above connection sites are carboxyl groups, and
15) When L² is a single bond, adjacent R₁₁ and R₂₀ which are not the above connection sites; and R₁₅ and R₁₆ may form a ring.

It is preferable that the polymer is prepared from a diamine monomer; a diacyl chloride monomer; and an anhydride monomer.

It is preferable that the diamine includes one or more monomers selected from the group consisting of 2,2'-bis (3-amino-4-hydroxyphenyl) hexafluoropropane, 2,2'-bis (3-amino-4-hydroxyphenyl)propane, 3,3'-dihydroxybenzidine, 4,4'-methylenebis(2-aminophenol), 4,4'-(cyclohexane-1,1-diyl)bis(2-aminophenol), 4,4'-(pentane-3,3-diyl)bis(2-aminophenol), 4,4'-(heptane-4,4-diyl)bis(2-aminophenol), 4,4'-(nonane-5,5-diyl)bis(2-aminophenol), 4,4'-(4-methylpentane-2,2-diyl)bis(2-aminophenol), 4,4'-(bis(trimethylsilyl)methylene)bis(2-aminophenol), or combinations thereof.

It is preferable that the diacyl chloride includes one or more monomers selected from the group consisting of 4,4'-oxybisbenzoyl chloride, 1,2-cyclobutanedicarboxylic acid dichloride, terephthaloyl chloride, isophthaloyl chloride, 4,4'-biphenyldicarbonyl chloride, 1,4-naphthalenedicarbonyl chloride, 4,4'-sulfonyldibenzoyl chloride, 1,4-cyclohexanedicarboxylic acid dichloride, or combinations thereof.

It is preferable that the anhydride includes one or more monomers selected from the group consisting of bicyclo[2.2.2]oct-5-ene-2,3-dicarboxylic anhydride, 5-norbornene-2,3-dicarboxylic anhydride, maleic anhydride, phthalic anhydride, succinic anhydride, or combinations thereof.

The polymer produced by the above production method preferably has a yield of 80% or more.

It is preferable that the above production method is produced by further including pyridine.

The polymer preferably has a weight average molecular weight of 5,000 to 40,000 g/mol.

A positive photosensitive composition prepared using the polymer resin preferably includes the polymer; a photosensitizer; a solvent; and an additive.

The photosensitizer preferably includes one or more of Formulas P-1 to P-8 below.

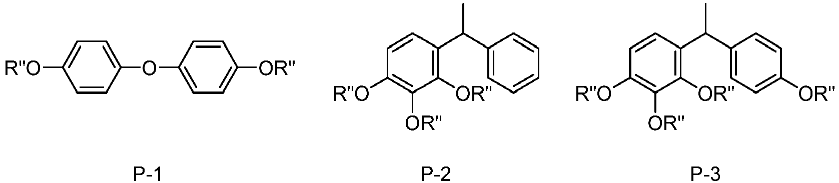

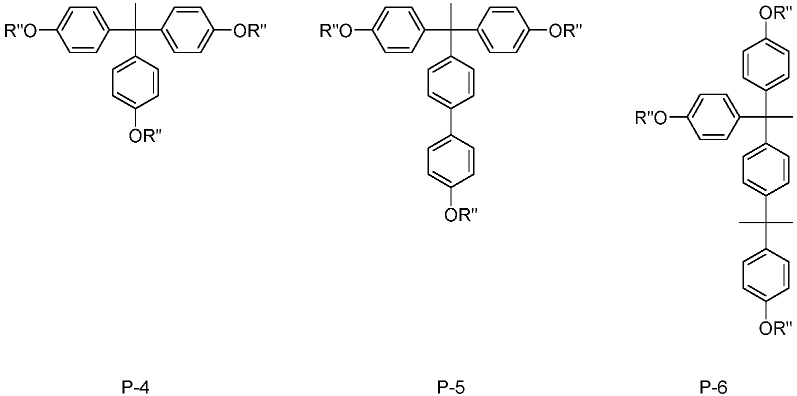

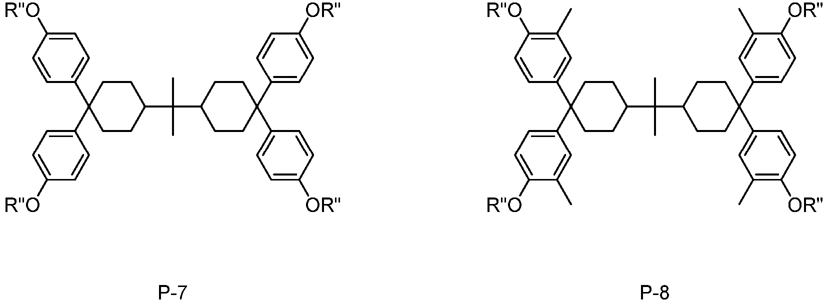

In P-1 to P-8, R" is hydrogen; Formula S-1 below; or Formula S-2 below.

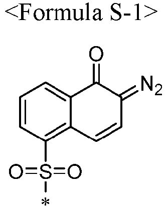

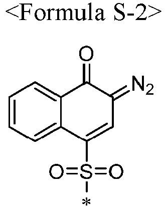

It is preferable that the solvent includes one or more selected from the group consisting of N,N-dimethylformamide, N-methylformanilide, N-methylacetamide, N,N-dimethylacetamide, dimethyl sulfoxide, benzyl ethyl ether, dihexyl ether, acetylacetone, gamma-butyrolactone, diethylene glycol monomethyl ether, diethylene glycol monoethyl ether, diethylene glycol dimethyl ether, diethylene glycol methyl ethyl ether, diethylene glycol diethyl ether, propylene glycol methyl ether acetate, propylene glycol propyl ether acetate, or combinations thereof.

It is preferable that the additive includes one or more selected from the group consisting of a silane-based coupling agent; a surface leveling agent; a surfactant; a crosslinking agent; or combinations thereof.

The polymer is preferably contained in an amount of 5 to 50% by weight based on the total amount of the composition.

The photosensitizer is preferably contained in an amount of 1 to 50% by weight based on the total amount of the composition.

The solvent is preferably contained in an amount of 40 to 95% by weight based on the total amount of the composition.

The additive is preferably contained in an amount of 0.001 to 10% by weight based on the total amount of the composition.

As another embodiment of the present disclosure, it is desirable to provide a pattern or film manufactured from the positive photosensitive composition.

As another embodiment of the present disclosure, it is desirable to provide a semiconductor device or display device manufactured using the above pattern or film.

As another embodiment of the present disclosure, it is desirable to provide an electronic device including the semiconductor device or display device and a control unit that drives the same.

### EFFECT OF INVENTION

Since the polymer of the present disclosure was synthesized using γ-butyrolactone as a single solvent, and as a polyoxazole-based precursor resin which does not contain solvents harmful to the environment and the human body, such as previously used N-methylpyrrolidone, and significantly reduces unreacted monomers that adversely affect mechanical properties, the polymer of the present disclosure is excellent in the yield due to the low proportion of unreacted monomers after the polymerization reaction, has no problem with residues during development, has high resolution of pattern realization, and has the effect of improving physical properties of a tensile strength of 10 MPa or more and an elongation of 10% or more of the post-heat treated film.

### DESCRIPTION OF EXEMPLARY EMBODIMENTS

Hereinafter, some embodiments of the present disclosure will be described in detail with reference to exemplary drawings. In adding reference numerals to components of each drawing, the same components may have the same reference numerals as far as possible even though they are indicated in different drawings.

When it is determined that a detailed description of a related known constitution or function may obscure the gist of the present disclosure in describing the present disclosure, the detailed description thereof may be omitted. When the expressions "includes", "has", "consisting of', *etc.* mentioned in this specification are used, other parts may be added unless "only" is used. When a component is expressed in the singular form, it may include a case in which the plural form is included unless otherwise explicitly stated.

In addition, in describing the components of the present disclosure, terms such as first, second, A, B, (a), (b), *etc.* may be used. Such terms are only for distinguishing the components from other components, and the essence, order, sequence, number, or *etc.* of the relevant components are not limited by the terms.

In the description of the positional relationship of the components, when two or more components are described as being "connected", "linked", or "fused", *etc.,* the two or more components may be directly "connected", "linked", or "fused", but it should be understood that the two or more components may also be "connected", "linked", or "fused" by way of a further "interposition" of a different component. Here, the different component may be included in any one or more of the two or more components that are to be "connected", "linked", or "fused" to each other.

In addition, when a component such as a layer, a film, a region, a plate, or *etc.* is described to be "on top" or "on" of another component, it should be understood that this may not only include a case where the component is "immediately on top of" another component, but also include a case where another component is disposed therebetween. In contrast, it should be understood that when a component is described to be "immediately on top of" another part, this may mean that there is not another part disposed therebetween.

In the description of the temporal flow relationship relating to the components, the operation method, or the preparation method, for example, when the temporal precedence or flow precedence is described by way of "after", "subsequently", "thereafter", "before", *etc.,* it may also include cases where the flow is not continuous unless terms such as "immediately" or "directly" are used.

Meanwhile, when the reference is made to numerical values or corresponding information for components, numerical values or corresponding information may be interpreted as including an error range that may occur due to various factors (e.g., process factors, internal or external shocks, noise, *etc*.) even if a separate explicit description is not present.

The terms used in this specification and the appended claims should not be construed as limited to their ordinary or dictionary meanings, and the terms must be interpreted with meaning and concept consistent with the technical idea of the present disclosure based on the principle that the inventor can appropriately define the concept of terms in order to explain his/her invention in the best possible way.

The term used in this application "halo" or "halogen" includes fluorine (F), chlorine (Cl), bromine (Br), and iodine (I) unless otherwise specified.

The term used in this application "alkyl" or "alkyl group" refers to a radical of saturated aliphatic functional groups having 1 to 60 carbons linked by a single bond unless otherwise specified, and including a linear chain alkyl group, a branched chain alkyl group, a cycloalkyl (alicyclic) group, an alkyl-substituted cycloalkyl group, and a cycloalkyl-substituted alkyl group.

The term used in this application "haloalkyl group" or "halogenalkyl group" refers to an alkyl group in which a halogen is substituted unless otherwise specified.

The term used in this application "alkenyl" or "alkynyl", unless otherwise specified, has a double bond or triple bond, respectively, includes a linear or branched chain group, and has 2 to 60 carbon atoms, but is not limited thereto.

The term used in this application "cycloalkyl" refers to alkyl which forms a ring having 3 to 60 carbon atoms unless otherwise specified, but is not limited thereto.

The term used in this application "alkoxy group" or "alkyloxy group" refers to an alkyl group to which an oxygen radical is bonded, and has 1 to 60 carbon atoms unless otherwise specified, but is not limited thereto.

The term used in this application "alkenoxyl group", "alkenoxy group", "alkenyloxyl group", or "alkenyloxy group" refers to an alkenyl group to which an oxygen radical is attached, and has 2 to 60 carbon atoms unless otherwise specified, but is not limited thereto.

The term used in this application "aryl group" and "arylene group" each have 6 to 60 carbon atoms unless otherwise specified, but are not limited thereto. The aryl group or arylene group in this application includes monocyclic compounds, ring assemblies, multiple fused cyclic compounds, *etc.* For example, the aryl group may include a phenyl group, a monovalent functional group of biphenyl, a monovalent functional group of naphthalene, a fluorenyl group, and a substituted fluorenyl group, and the arylene group may include a fluorenylene group and a substituted fluorenylene group.

The term used in this application "ring assemblies" means that two or more ring systems (monocyclic or fused ring systems) are directly connected to each other through a single bond or double bond, and the number of direct links between such rings is one less than the total number of ring systems contained in the compound. In the ring assemblies, the same or different ring systems may be directly connected to each other through a single bond or double bond.

Since the aryl group in this application includes ring assemblies, the aryl group includes biphenyl and terphenyl in which a benzene ring, which is a single aromatic ring, is connected by a single bond. In addition, since the aryl group also includes a compound in which an aromatic ring system fused to an aromatic single ring is connected by a single bond, it also includes, for example, a compound in which a benzene ring, which is an aromatic single ring, and fluorine, which is a fused aromatic ring system, are linked by a single bond.

The term used in this application "multiple fused ring systems" refers to a fused ring form in which at least two atoms are shared, and it includes a form in which ring systems of two or more hydrocarbons are fused, a form in which at least one heterocyclic system including at least one heteroatom is fused, *etc.* Such multiple fused ring systems may be an aromatic ring, a heteroaromatic ring, an aliphatic ring, or a combination of these rings. For example, in the case of an aryl group, it may be a naphthalenyl group, a phenanthrenyl group, a fluorenyl group, *etc.,* but is not limited thereto.

The term used in this application "a spiro compound" has "a spiro union", and the spiro union refers to a linkage in which two rings are formed by sharing only one atom. At this time, the atom shared by the two rings is called a "spiro atom", and they are each called "monospiro-", "dispiro-", and "trispiro-" compounds depending on the number of spiro atoms included in a compound.

The terms used in this application "fluorenyl group", "fluorenylene group", and "fluorenetriyl group" refer to a monovalent, divalent, or trivalent functional group in which R, R', R", and R‴ are all hydrogen in the following structures, respectively, unless otherwise specified, "substituted fluorenyl group", "substituted fluorenylene group", or "substituted fluorenetriyl group" means that at least one of the substituents R, R', R", and R‴ is a substituent other than hydrogen, and cases where R and R' are bound to each other to form a spiro compound together with carbon to which they are linked are included. In this specification, all of the fluorenyl group, the fluorenylene group, and the fluorenetriyl group may also be referred to as a fluorene group regardless of valences such as monovalent, divalent, trivalent, *etc.*

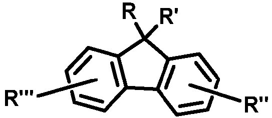

In addition, R, R', R", and R‴ may each independently be an alkyl group having 1 to 20 carbon atoms, an alkenyl group having 1 to 20 carbon atoms, an aryl group having 6 to 30 carbon atoms, and a heterocyclic group having 2 to 30 carbon atoms and, for example, the aryl group may be phenyl, biphenyl, naphthalene, anthracene, or phenanthrene, and the heterocyclic group may be pyrrole, furan, thiophene, pyrazole, imidazole, triazole, pyridine, pyrimidine, pyridazine, pyrazine, triazine, indole, benzofuran, quinazoline, or quinoxaline. For example, the substituted fluorenyl group and the fluorenylene group may each be a monovalent functional group or divalent functional group of 9,9-dimethylfluorene, 9,9-diphenylfluorene, and 9,9'-spirobi[9H-fluorene].

The term used in this application "heterocyclic group" includes not only an aromatic ring such as "heteroaryl group" or "heteroarylene group", but also a non-aromatic ring, and refers to a ring having 2 to 60 carbon atoms each including one or more heteroatoms unless otherwise specified, but is not limited thereto. The term used in this application "heteroatom" refers to N, O, S, P, or Si unless otherwise specified, and the heterocyclic group refers to a monocyclic group including a heteroatom, ring assemblies, multiple fused ring systems, spiro compounds, *etc.*

For example, the "heterocyclic group" may also include a compound including a heteroatom group such as SO₂, P=O, *etc.* such as the compound shown below, instead of carbon that forms a ring.

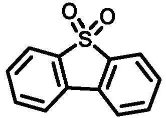

The term used in this application "ring" includes monocyclic and polycyclic rings, includes heterocycles containing at least one heteroatom as well as hydrocarbon rings, and includes aromatic and non-aromatic rings.

The term used in this application "polycyclic" includes ring assemblies such as biphenyl, terphenyl, *etc.,* multiple fused ring systems, and spiro compounds, includes non-aromatic as well as aromatic compounds, and includes heterocycles containing at least one heteroatom as well as hydrocarbon rings.

The term used in this application "alicyclic group" refers to cyclic hydrocarbons other than aromatic hydrocarbons, includes monocyclic compounds, ring assemblies, multiple fused ring systems, spiro compounds, *etc.,* and refers to a ring having 3 to 60 carbon atoms unless otherwise specified, but is not limited thereto. For example, even when benzene, which is an aromatic ring, and cyclohexane, which is a non-aromatic ring, are fused, the alicyclic group corresponds to an aliphatic ring.

In addition, when prefixes are named consecutively, it means that the substituents are listed in the order they are described. For example, in the case of an arylalkoxy group, it means an alkoxy group substituted with an aryl group, in the case of an alkoxycarbonyl group, it means a carbonyl group substituted with an alkoxy group, and further in the case of an arylcarbonyl alkenyl group, it means an alkenyl group substituted with an arylcarbonyl group, wherein the arylcarbonyl group is a carbonyl group substituted with an aryl group.

In addition, unless otherwise explicitly specified, "substituted" in the term used in this application "substituted or unsubstituted" refers to a substitution with one or more substituents selected from the group consisting of deuterium, a halogen, an amino group, a nitrile group, a nitro group, a C₁-C₃₀ alkyl group, a C₁-C₃₀ alkoxy group, a C₁-C₃₀ alkylamine group, a C₁-C₃₀ alkylthiophene group, a C₆-C₃₀ arylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryl group substituted with deuterium, a C₈-C₃₀ arylalkenyl group, a silane group, a boron group, a germanium group, and a C₂-C₂₀ heterocyclic group containing at least one heteroatom selected from the group consisting of O, N, S, Si, and P, but is not limited to these substituents.

Although the "names of functional groups" corresponding to the aryl group, arylene group, heterocyclic group, *etc.* exemplified as examples of each symbol and a substituent thereof in this application may be described as "names of the functional groups reflecting their valences", they may also be described as the "names of their parent compounds". For example, in the case of "phenanthrene", which is a type of an aryl group, the names of the groups may also be described such that the monovalent "group" is divided and described as "phenanthryl (group)", and the divalent "group" is divided and described as "phenanthrylene (group)", *etc.,* but may also be described as "phenanthrene", which is the name of its parent compound regardless of its valence.

Similarly, in the case of pyrimidine as well, it may be described as "pyrimidine" regardless of its valence, or it may also be described as the "name of the group" of the relevant valence such as pyrimidinyl (group) in the case of monovalent and pyrimidinylene (group) in the case of divalent. Therefore, when the type of a substituent in this application is described as the name of its parent compound, it may refer to an n-valent "group" formed by detachment of a hydrogen atom bonded to a carbon atom and/or hetero atom of its parent compound.

In addition, in describing the names of the compounds or the substituents in this specification, the numbers, alphabets, *etc.* indicating positions may be omitted. For example, pyrido[4,3-d]pyrimidine may be described as pyridopyrimidine, benzofuro[2,3-d]pyrimidine may be described as benzofuropyrimidine, and 9,9-dimethyl-9H-fluorene may be described as dimethylfluorene. Therefore, both benzo[g]quinoxaline and benzo[f]quinoxaline may be described as benzoquinoxaline.

In addition, unless there is an explicit description, the formulas used in this application are applied in the same manner as in the definition of substituents by the exponent definition of the formula below.

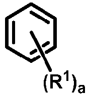

Here, when a is an integer of 0, it means that the substituent R1 is not present, that is, when a is 0, it means that hydrogen is bonded to all carbons that form a benzene ring, and at this time, the indication of hydrogen bonded to carbons may be omitted, and the formula or compound may be described. In addition, when a is an integer of 1, one substituent R¹ may be bonded to any one of carbons forming a benzene ring, when a is an integer of 2 or 3, it may be bonded, for example, as shown below, even when a is an integer of 4 to 6, it may be bonded to carbons of a benzene ring in a similar manner, and when a is an integer of 2 or more, R¹ may be the same as or different from each other.

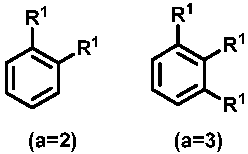

Unless otherwise specified in the present application, forming a ring means that adjacent groups bind to one another to form a single ring or multiple fused rings, and the single ring and the formed multiple fused rings may include a heterocycle containing at least one heteroatom as well as a hydrocarbon ring, and include aromatic and non-aromatic rings.

In addition, unless otherwise specified in this specification, when indicating a condensed ring, the number in "number-condensed ring" indicates the number of rings to be condensed. For example, a form in which three rings such as anthracene, phenanthrene, benzoquinazoline, *etc.* are condensed with one another may be marked as a 3-condensed ring.

Meanwhile, the term used in this application "bridged bicyclic compound" refers to a compound in which two rings share 3 or more atoms to form a ring unless otherwise specified. At this time, the shared atoms may include carbon or a hetero atom.

Hereinafter, embodiments of the present disclosure will be described in detail. However, these embodiments are presented as examples, and the present disclosure is not limited thereby, and the present disclosure is only defined by the scope of the claims to be described later.

A positive photosensitive composition including a polymer and a precursor according to one embodiment of the present disclosure may be used to prepare an insulating film, a surface protective film, and a redistribution layer of a semiconductor device; and a pixel defining layer (PDL) of a display device.

In preparing a positive photosensitive composition for application to a semiconductor device or display device according to one embodiment of the present disclosure, the following additives may be additionally included to improve required properties.

As an additive that can be added according to one embodiment of the present disclosure, a surface leveling agent may be additionally included in order to maintain a constant thickness of the coating film when coating it on the substrate. A surfactant may be additionally included to ensure constant coating depending on the characteristics of the substrate surface, and a silane-based coupling agent may be additionally included to adjust adhesion to the substrate surface. In the heat treatment step, a crosslinking agent may be additionally included to strengthen the bonds between polymer molecules.

The elements that make up the positive photosensitive composition are as follows.

### (1) Polymer

The resin for patterning according to one embodiment of the present disclosure may include a polymer.

The polymer refers to a resin including a hydroxyamide-based precursor that may be formed into a polymer through chemical or thermal treatment.

The polymer may be contained in an amount of 5% by weight to 50% by weight, preferably 10% by weight to 45% by weight, based on the total amount of the positive photosensitive composition.

The polymer includes precursors represented by Formula 1-1 below; Formula 1-2 below; Formula 1-3 below; and Formula 1-4 below, but are not limited thereto. These may be used alone or in combinations of two or more thereof.

The polymer preferably includes a repeating unit selected from the group consisting of Formula 1-1 below; Formula 1-2 below; Formula 1-3 below; Formula 1-4 below; and combinations of two or more of Formulas 1-1 to 1-4.

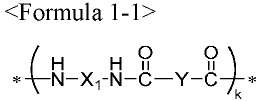

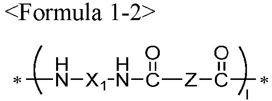

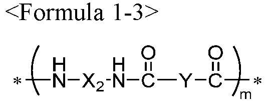

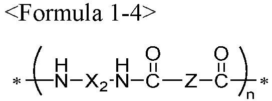

In a group consisting of Formula 1-1 above; Formula 1-2 above; Formula 1-3 above; Formula 1-4 above; and combinations of two or more of Formulas 1-1 to 1-4 above,
1) * is a part where the bonds are connected as repeating units,
2) * at the end of the polymer is a part where Formulas Q-1 to Q-10 are bonded by an amide bond or imide bond,
3) X₁ or X₂ is Formula 2 below,
4) Y is selected from the group consisting of: a C₆ to C₃₀ arylene group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkylene group; a C₁ to C₂₀ cycloalkylene group; a C₂ to C₂₀ alkenylene group; a C₃ to C₂₀ cycloalkenylene group; a C₂ to C₂₀ alkynylene group; a C₃ to C₂₀ cycloalkynylene group; Formula 2; or combinations thereof,
5) Z is selected from the group consisting of: a C₆ to C₃₀ arylene group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkylene group; a C₁ to C₂₀ cycloalkylene group; a C₂ to C₂₀ alkenylene group; a C₃ to C₂₀ cycloalkenylene group; a C₂ to C₂₀ alkynylene group; a C₃ to C₂₀ cycloalkynylene group; Formula 3; or combinations thereof,
6) k, l, m, and n are integers of 1 or more, 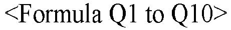 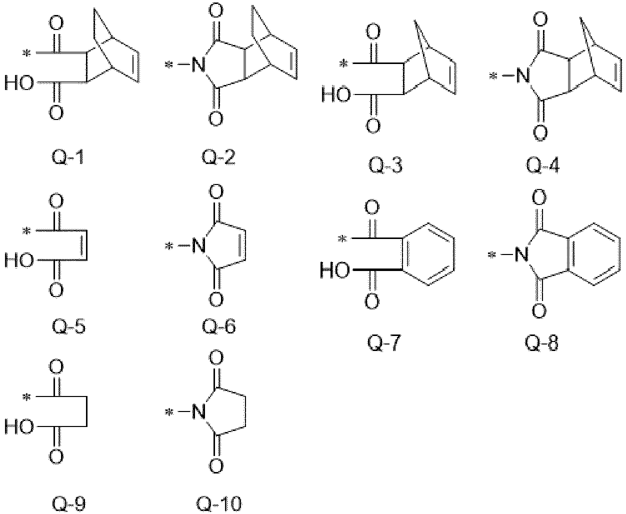
7) The polymer terminal is one in which a formula selected from the group consisting of one selected from the Formulas Q-1 to Q-10 above or combinations thereof is bonded by an amide or imide bond,

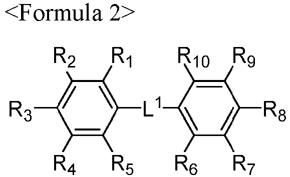

In Formula 2,
8) L¹ is selected from the group consisting of a single bond, -CH₂-, -CH₂CH₂-,-CH₂OCH₂-, -CH(CH₃)-, -C(CH₃)₂-, -C(C₂H₅)₂-, -C(C₃H₇)₂-, -C(C₄H₉)₂-, -C(C₅H₁₁)₂-, -C(C₆H₁₃)₂-, -C(C₅H₁₀)-, -O-, -CH(CF₃)-, -C(CF₃)₂-, -S-, -SO₂-, Si(CH₃)₂-, -C₆H₄-, -CO-, -NHCO-, and -COO-,
9) Two of R₁ to R₁₀ are connection sites with amide groups of Formulas 1-1 and 1-2,
10) Residual R₁ to R₁₀ except for the above connection sites are each independently hydrogen; heavy hydrogen; a hydroxyl group; an C₆ to C₃₀ aryl group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkyl group; a C₂ to C₂₀ alkenyl group; a C₂ to C₂₀ alkyne group; a C₁ to C₂₀ alkoxy group; a C₆ to C₃₀ aryloxy group; a fluorenyl group; a carbonyl group; an ether group; a carboxyl group; or a C₁ to C₂₀ alkoxycarbonyl group,
11) When L¹ is a single bond, adjacent R₁ and R₁₀ which are not the connection sites; and R₅ and R₆ may form a ring,

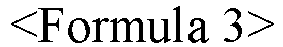

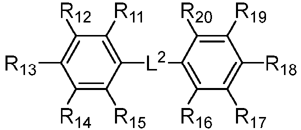

In Formula 3,
12) L² is selected from the group consisting of a single bond, -CH₂-, -CH₂CH₂-,-CH₂OCH₂-, -CH(CH₃)-, -C(CH₃)₂-, -C(C₂H₅)₂-, -C(C₃H₇)₂-, -C(C₄H₉)₂-, -C(C₅H₁₁)₂-, -C(C₆H₁₃)₂-, -C(C₅H₁₀)-, -O-, -CH(CF₃)-, -C(CF₃)₂-, -S-, -SO₂-, Si(CH₃)₂-, -C₆H₄-, -CO-, -NHCO-, and -COO-,
13) Two of R₁₁ to R₂₀ are connection sites with amide groups of Formulas 1-1 and 1-2,
14) Residual R₁₁ to R₂₀ except for the above connection sites are each independently hydrogen; heavy hydrogen; a hydroxyl group; an C₆ to C₃₀ aryl group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkyl group; a C₂ to C₂₀ alkenyl group; a C₂ to C₂₀ alkyne group; a C₁ to C₂₀ alkoxy group; a C₆ to C₃₀ aryloxy group; a fluorenyl group; a carbonyl group; an ether group; a carboxyl group; or a C₁ to C₂₀ alkoxycarbonyl group, and provided that two of residual R₁₁ to R₂₀ except for the above connection sites are carboxyl groups, and
15) When L² is a single bond, adjacent R₁₁ and R₂₀ which are not the above connection sites; and R₁₅ and R₁₆ may form a ring.

The polymer according to one embodiment of the present disclosure is produced using γ-butyrolactone as a single solvent, and thus has little environmental and human hazard and excellent yield of a reactant (polymer).

It is desirable that the polymer prepared by the above production method has a yield of 80% or more, preferably 82.5% or more.

In the above production method, it is preferable that pyridine is further added. When pyridine is added, the compatibility between γ-butyrolactone and the monomer increases, and in addition, since it acts as a catalyst for the polymerization reaction, the polymerization reaction may occur more efficiently.

The polymer resin may have a weight average molecular weight of 5,000 g/mol to 30,000 g/mol, preferably 5,000 g/mol to 40,000 g/mol, and more preferably 7,000 g/mol to 25,000 g/mol. When the weight average molecular weight of the resin is within the above-described range, no residue remains in the exposed layer during development, loss of film thickness in the non-exposed layer is minimized, and a good pattern may be obtained. The resin may be contained in an amount of 5 to 50% by weight, more preferably 10 to 45% by weight, based on the total amount of the photosensitive composition. When the resin is contained within the above-described range, a constant film thickness may be obtained in the coating step, and excellent sensitivity, developability, and adhesion may be obtained.

### (2) Photosensitizer

The photosensitizer is a photosensitizer commonly used in positive photosensitive compositions, and may include, for example, photosensitive diazoquinone compounds, *etc.,* and specifically phenolic compounds, and photosensitive compounds represented by Formulas P-1 to P-8 below, and specific examples of R" may include hydrogen; heavy hydrogen; and compounds including 1,2-naphthoquinone-2-diazido-5-sulfonic acid or 1,2-naphthoquinone-2-diazido-4-sulfonic acid in the structure.

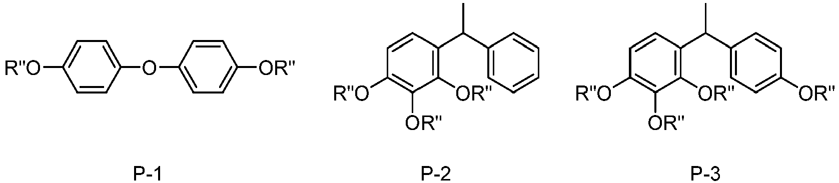

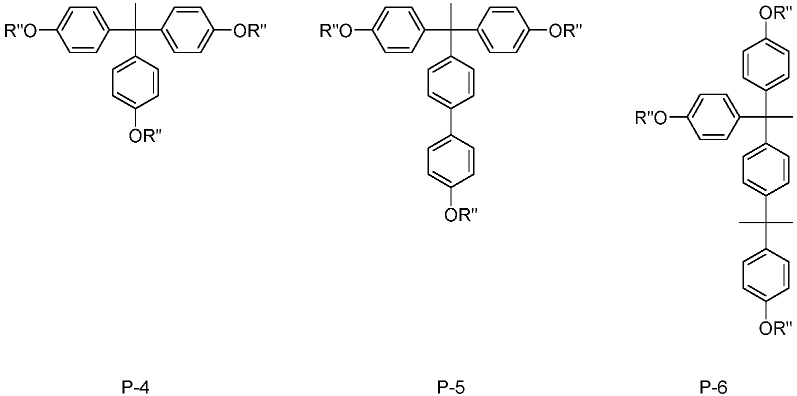

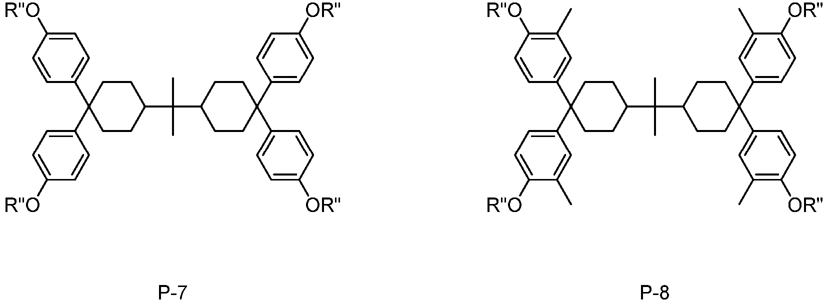

In P-1 to P-8, R" is hydrogen; Formula S-1 below; or Formula S-2 below.

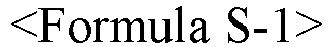

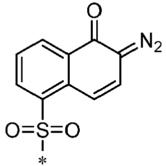

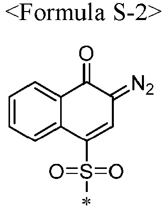

In Formula S-1 and Formula S-2, * represents a connection site.

The photosensitizer is preferably contained in an amount of 1 to 50% by weight based on the total amount of the composition.

### (3) Solvent

The solvent may use materials that are compatible with, but does not react with, the polymer resin, the photosensitizer, and the pigment.

Examples of the solvent include alcohols such as methanol, ethanol, *etc.;* ethers such as dichloroethyl ether, *n*-butyl ether, diisoamyl ether, methylphenyl ether, tetrahydrofuran, *etc*.; glycol ethers such as ethylene glycol monomethyl ether, ethylene glycol monoethyl ether, *etc.;* cellosolve acetates such as methyl cellosolve acetate, ethyl cellosolve acetate, diethyl cellosolve acetate, *etc.;* carbitols such as methylethyl carbitol, diethyl carbitol, diethylene glycol monomethyl ether, diethylene glycol monoethyl ether, diethylene glycol dimethyl ether, diethylene glycol methyl ethyl ether, diethylene glycol diethyl ether, *etc.;* propylene glycol alkyl ether acetates such as propylene glycol methyl ether acetate, propylene glycol propyl ether acetate, *etc.*; aromatic hydrocarbons such as toluene, xylene, *etc.;* ketones such as methyl ethyl ketone, cyclohexanone, 4-hydroxy-4-methyl-2-pentanone, methyl-*n*-propyl ketone, methyl-*n*-butyl ketone, methyl-*n*-amyl ketone, 2-heptanone, *etc*.; saturated aliphatic monocarboxylic acid alkyl esters such as ethyl acetate, *n*-butyl acetate, isobutyl acetate, *etc.;* lactic acid esters such as methyl lactate, ethyl lactate, *etc.;* oxyacetic acid alkyl esters such as methyl oxyacetate, ethyl oxyacetate, butyl oxyacetate, *etc*.; alkoxy acetate alkyl esters such as methoxy methyl acetate, methoxy ethyl acetate, methoxy butyl acetate, ethoxy methyl acetate, ethoxy ethyl acetate, *etc*.; 3-oxypropionic acid alkyl esters such as 3-oxy methyl propionate, 3-oxy ethyl propionate, *etc*.; 3-alkoxy propionic acid alkyl esters such as 3-methoxy methyl propionate, 3-methoxy ethyl propionate, 3-ethoxy ethyl propionate, 3-ethoxy methyl propionate, *etc*.; 2-oxypropionic acid alkyl esters such as methyl 2-oxypropionate, ethyl 2-oxypropionate, propyl 2-oxypropionate, *etc*.; 2-alkoxy propionic acid alkyl esters such as 2-methoxy methyl propionate, 2-methoxy ethyl propionate, 2-ethoxy ethyl propionate, 2-ethoxy methyl propionate, *etc.;* monooxy monocarboxylic acid alkyl esters of 2-oxy-2-methyl propionic acid esters such as 2-oxy-2-methyl methyl propionate, 2-oxy-2-methyl ethyl propionate, *etc.,* and 2-alkoxy-2-methyl propionic acid alkyls such as 2-methoxy-2-methyl methyl propionate, 2-ethoxy-2-methyl ethyl propionate, *etc.;* esters such as 2-hydroxyethyl propionate, 2-hydroxy-2-methyl ethyl propionate, ethyl hydroxyacetate, 2-hydroxy-3-methyl methyl butanoate, *etc.;* and ketonic acid esters such as ethyl pyruvate, *etc.*

Further, high-boiling point solvents such as N-methylformamide, *N,N-*dimethylformamide, *N*-methylformanilide, *N*-methylacetamide, *N,N-*dimethylacetamide, *N-*methylpyrrolidone, dimethyl sulfoxide, benzyl ethyl ether, dihexyl ether, acetylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, and phenyl cellosolve acetate may also be used.

Considering compatibility and reactivity, glycol ethers such as ethylene glycol monoethyl ether, *etc.;* ethylene glycol alkyl ether acetates such as ethyl cellosolve acetate, *etc.;* esters such as ethyl 2-hydroxypropionate, *etc.;* carbitols such as diethylene glycol monomethyl ether, *etc*.); and propylene glycol alkyl ether acetates such as propylene glycol methyl ether acetate, propylene glycol propyl ether acetate, *etc.* among the above solvents may be used.

The solvent may be contained in a balance amount based on the total amount of the photosensitive composition, and specifically in an amount of 50 to 95% by weight. When the solvent is contained within the above-described range, the processability when preparing the pattern layer is excellent as the positive photosensitive composition has an appropriate viscosity.

### (4) Other additives

In order to prevent stains or spots upon application, to improve leveling performance, and to prevent the creation of residues due to non-development, the positive photosensitive resin composition may further include additives such as malonic acid; 3-amino-1,2-propanediol; a silane-based coupling agent containing a vinyl group or (meth)acryloxy group; a surface leveling agent; a surfactant; and a crosslinker.

For example, the photosensitive resin composition may further include a silane-based coupling agent having a reactive substituent such as a vinyl group, a carboxyl group, a methacryloxy group, an isocyanate group, an epoxy group, or the like in order to improve adhesion to a substrate, *etc.*

Examples of the silane-based coupling agent may include trimethoxysilyl benzoic acid, γ-methacryloxypropyl trimethoxysilane, vinyl triacetoxysilane, vinyl trimethoxysilane, γ-isocyanate propyl triethoxysilane, γ-glycidoxy propyl trimethoxy silane, β-epoxy cyclohexyl ethyl trimethoxy silane, silane-based coupling agents commercially available under names such as KBM-502, KBM-602, KBM-573, and KBE-9007N from Shinetsu Silicon, *etc.,* and these may be used alone or in mixtures of two or more.

The silane-based coupling agent may be contained in an amount of 0.01 part by weight to 10 parts by weight based on 100 parts by weight of the photosensitive resin composition. When the silane-based coupling agent is contained within the above-described range, adhesion, storability, *etc.* are excellent.

In addition, the photosensitive resin composition may further include a surface smoother to form a film with a constant thickness in the coating step if necessary.

The surface smoother may include surface smoothers commercially available under the names of DIC's F-554^{®}, F-556^{®}, F-557^{®}, F-559^{®}, F-560^{®}, F-563^{®}, RS-72-K^{®}, R-40^{®}, R-41^{®}, R-43^{®}, *etc.;* and BASF's Efka^{®} FL3740, Efka^{®} FL3741, Efka^{®} FL3745, and Efka^{®} FL3770.

The surface smoother may be used in an amount of 0.001 to 5 parts by weight based on 100 parts by weight of the photosensitive resin composition. When the surface smoother is contained within the above-described range, coating uniformity may be secured and the film may be coated to a constant thickness.

In addition, the photosensitive resin composition may further include a surfactant to improve coating properties and obtain an effect of preventing the formation of defects if necessary.

The surfactant may include surfactants commercially available under the names of: BM-1000^{®}, BM-1100^{®}, *etc.* from BM Chemie; Mega pack F 142D^{®}, Mega pack F 172^{®}, Mega pack F 173^{®}, Mega pack F 183^{®}, *etc.* from Dainippon Ink Kagaku Kogyo; Fluorad FC-135^{®}, Fluorad FC-170C^{®}, Fluorad FC-430^{®}, Fluorad FC-431^{®}, *etc.* from Sumitomo 3M; Saffron S-112^{®}, Saffron S-113^{®}, Saffron S-131^{®}, Saffron S-141^{®}, Saffron S-145^{®}, *etc.* from Asahi Grass; and SH-28PA^{®}, SH-190^{®}, SH-193^{®}, SZ-6032^{®}, SF-8428^{®}, *etc.* from Toray Silicone.

The surfactant may be used in an amount of 0.001 to 5 parts by weight based on 100 parts by weight of the photosensitive resin composition. When the surfactant is contained within the above-described range, coating uniformity may be secured, stains may not occur, and wetting to the glass substrate is excellent.

As the crosslinker, 1,4-bis(methoxymethyl)benzene, diethyl sulfate, 3-aminopropyltriethoxysilane, N,N'-methylenebisacrylamide, *etc.* may be used, and these may be mixed and used either alone or in combinations of two or more thereof.

The crosslinker may be used in an amount of 0.001 to 5 parts by weight based on 100 parts by weight of the photosensitive resin composition. When the crosslinker is contained within the above-described range, it is advantageous to appropriately provide physical properties of the cured coating film, for example, mechanical properties such as tensile strength.

In addition, other additives may be added to the photosensitive resin composition in certain amounts within ranges that do not impair the physical properties.

Hereinafter, Synthesis Examples and Examples according to the present disclosure will be described in detail, but Synthesis Examples and Examples of the present disclosure are not limited thereto.

### Synthesis Example 1

After installing a 250ml 3-neck round bottom flask by attaching a stirrer, a nitrogen injection device, a dropping funnel, a temperature controller, and a cooler thereto, filling it with nitrogen and 120.47 g of γ-butyrolactone (GBL), and then injecting 15 g of 2,2'-bis(3-amino-4-hydroxyphenyl)hexafluoropropane and 2.58 g of pyridine thereinto, the mixture was stirred and maintained at 40°C. After 0.910 g of phthalic anhydride was slowly injected thereinto, the mixture was stirred for a certain period of time to dissolve and react it. Thereafter, the solution was maintained at a temperature of 5°C and stirred for 30 minutes. Afterwards, 10.58 g of 4,4'-oxybisbenzoyl chloride was slowly injected thereinto to dissolve it, and the reaction was performed while performing stirring for 12 hours.

After stirring the polyhydroxyamide solution at room temperature for 1 hour, it was precipitated with methanol, and the precipitated solid was dried in vacuum at 60°C for 12 hours to obtain a copolymerized polyhydroxyamide powder with a yield of 87.56%.

### Synthesis Example 2

After installing a 250ml 3-neck round bottom flask by attaching a stirrer, a nitrogen injection device, a dropping funnel, a temperature controller, and a cooler thereto, filling it with nitrogen and 65.7 g of γ-butyrolactone (GBL), and then injecting 15 g of 2,2'-bis(3-amino-4-hydroxyphenyl)hexafluoropropane and 0.52 g of pyridine thereinto, the mixture was stirred and maintained at 40°C. After 0.910 g of phthalic anhydride was slowly injected thereinto, the mixture was stirred for a certain period of time to dissolve and react it. Thereafter, 52.70 g of GBL and 2.06 g of pyridine were added to the flask where the reaction was in progress, and then the solution was maintained at a temperature of 5°C and stirred for 30 minutes. Afterwards, 8.76 g of 4,4'-biphenyldicarbonyl chloride was slowly injected thereinto to dissolve it, and the reaction was performed while performing stirring for 12 hours.

After stirring the polyhydroxyamide solution at room temperature for 1 hour, it was precipitated with methanol, and the precipitated solid was dried in vacuum at 60°C for 12 hours to obtain a copolymerized polyhydroxyamide powder with a yield of 85.47%.

### Synthesis Example 3

After installing a 250ml 3-neck round bottom flask by attaching a stirrer, a nitrogen injection device, a dropping funnel, a temperature controller, and a cooler thereto, filling it with nitrogen and 65.7 g of γ-butyrolactone (GBL), and then injecting 15 g of 2,2'-bis(3-amino-4-hydroxyphenyl)hexafluoropropane and 0.52 g of pyridine thereinto, the mixture was stirred and maintained at 40°C. After 1.54 g of 5-norbornene-2,3-dicarboxylic anhydride was slowly injected thereinto, the mixture was stirred for a certain period of time to dissolve and react it. Thereafter, 52.70 g of GBL and 2.06 g of pyridine were added to the flask where the reaction was in progress, and then the solution was maintained at a temperature of 5°C and stirred for 30 minutes. Afterwards, 9.48 g of 4,4'-oxybisbenzoyl chloride was slowly injected thereinto to dissolve it, and the reaction was performed while performing stirring for 12 hours.

After stirring the polyhydroxyamide solution at room temperature for 1 hour, it was precipitated with methanol, and the precipitated solid was dried in vacuum at 60°C for 12 hours to obtain a copolymerized polyhydroxyamide powder with a yield of 87.23%.

### Synthesis Example 4

After installing a 250ml 3-neck round bottom flask by attaching a stirrer, a nitrogen injection device, a dropping funnel, a temperature controller, and a cooler thereto, filling it with nitrogen and 65.7 g of γ-butyrolactone (GBL), and then injecting 15 g of 2,2'-bis(3-amino-4-hydroxyphenyl)propane and 0.52 g of pyridine thereinto, the mixture was stirred and maintained at 40°C. After 0.91 g of phthalic anhydride was slowly injected thereinto, the mixture was stirred for a certain period of time to dissolve and react it. Thereafter, 52.70 g of GBL and 2.06 g of pyridine were added to the flask where the reaction was in progress, and then the solution was maintained at a temperature of 5°C and stirred for 30 minutes. Afterwards, 11.95 g of 1,4-4,4'-oxybisbenzoyl chloride was slowly injected thereinto to dissolve it, and the reaction was performed while performing stirring for 12 hours.

After stirring the polyhydroxyamide solution at room temperature for 1 hour, it was precipitated with methanol, and the precipitated solid was dried in vacuum at 60°C for 12 hours to obtain a copolymerized polyhydroxyamide powder with a yield of 84.77%.

### Comparative Example 1

After installing a 250ml 3-neck round bottom flask by attaching a stirrer, a nitrogen injection device, a dropping funnel, a temperature controller, and a cooler thereto, filling it with nitrogen and 65.7g of N-methylpyrrolidone (NMP), and then injecting 15 g of 2,2'-bis(3-amino-4-hydroxyphenyl)hexafluoropropane and 0.52 g of pyridine thereinto, the mixture was stirred and maintained at 40°C. After 0.910 g of phthalic anhydride was slowly injected thereinto, the mixture was stirred for a certain period of time to dissolve and react it. Thereafter, 54.77 g of NMP and 2.06 g of pyridine were added to the flask where the reaction was in progress, and then the solution was maintained at a temperature of 5°C and stirred for 30 minutes. Afterwards, 10.58 g of 4,4'-oxybisbenzoyl chloride was slowly injected thereinto to dissolve it, and the reaction was performed while performing stirring for 12 hours.

After stirring the polyhydroxyamide solution at room temperature for 1 hour, it was precipitated with methanol, and the precipitated solid was dried in vacuum at 60°C for 12 hours to obtain a copolymerized polyhydroxyamide powder with a yield of 76.42%.

### Comparative Example 2

After installing a 250ml 3-neck round bottom flask by attaching a stirrer, a nitrogen injection device, a dropping funnel, a temperature controller, and a cooler thereto, filling it with nitrogen and 65.7g of N-methylpyrrolidone (NMP), and then injecting 15 g of 2,2'-bis(3-amino-4-hydroxyphenyl)propane and 0.52 g of pyridine thereinto, the mixture was stirred and maintained at 40°C. After 0.910 g of phthalic anhydride was slowly injected thereinto, the mixture was stirred for a certain period of time to dissolve and react it. Thereafter, 54.77 g of NMP and 2.06 g of pyridine were added to the flask where the reaction was in progress, and then the solution was maintained at a temperature of 5°C and stirred for 30 minutes. Afterwards, 11.95 g of 4,4'-oxybisbenzoyl chloride was slowly injected thereinto to dissolve it, and the reaction was performed while performing stirring for 12 hours.

After stirring the polyhydroxyamide solution at room temperature for 1 hour, it was precipitated with methanol, and the precipitated solid was dried in vacuum at 60°C for 12 hours to obtain a copolymerized polyhydroxyamide powder with a yield of 73.82%.

**[Table 1]**

| | **Yield (%)** | **Unreacted monomer ratio (%)** |
|---|---|---|
| **Synthesis Example 1** | 87.56 | 2.48 |
| **Synthesis Example 2** | 85.47 | 2.95 |
| **Synthesis Example 3** | 87.23 | 1.74 |
| **Synthesis Example 4** | 84.77 | 2.26 |
| **Comparative Example 1** | 76.42 | 5.54 |
| **Comparative Example 2** | 73.82 | 6.15 |

As results of the synthesis test shown in Table 1, results could be obtained with yields exceeding 84% in all of Examples 1 to 4, and it was confirmed that these are 8% or more higher than yields of Comparative Examples 1 and 2. In addition, it was confirmed that the ratio of unreacted monomer remaining in Comparative Examples 1 to 2 was more than 5% compared to Synthesis Examples 1 to 4.

### (Preparation Example 1) Preparation of positive photosensitive composition

13.759 g of a polymer resin obtained in Synthesis Examples 1 to 4 and Comparative Examples 1 to 2, 2.052 g of MIPHOTO TPD523 (Miwon Trading Co., Ltd.), 0.013 g of F-563 (DIC Co., Ltd.), 1.7 g of KBM-573 (Shinetsu Silicon Co., Ltd.), and 1.2 g of 1,4-bis(methoxymethyl)benzene were stirred with 32.5 g of γ-butyrolactone at room temperature for 12 hours. Subsequently, a photosensitive resin composition was prepared by removing impurities by filtering the composition three times.

A photosensitive composition solution was prepared with the compositions shown in Table 2 below.

**[Table 2]**

| | **Precursor** | **MIPHOTO TPD523 (%)** | **F-563 (%)** | **KBM-573 (%)** | **1,4-bis(methoxy methyl)benzene (%)** | **γ-butyrolactone (%)** |
|---|---|---|---|---|---|---|
| **Example 1** | Synthesis Example 1 26.80% | 4.00 | 0.02 | 0.33 | 0.23 | 63.3 |
| **Example 2** | Synthesis Example 2 26.80% | 4.00 | 0.02 | 0.33 | 0.23 | 63.3 |
| **Example 3** | Synthesis Example 3 26.80% | 4.00 | 0.02 | 0.33 | 0.23 | 63.3 |
| **Example 4** | Synthesis Example 4 26.80% | 4.00 | 0.02 | 0.33 | 0.23 | 63.3 |
| **Comparative Example 3** | Comparative Example 1 26.80% | 4.00 | 0.02 | 0.33 | 0.23 | 63.3 |
| **Comparative Example 4** | Comparative Example 2 26.80% | 4.00 | 0.02 | 0.33 | 0.23 | 63.3 |

The method of manufacturing a UTM specimen using the positive photosensitive resin composition is as follows.

### (1) Application and coating steps

The photosensitive composition prepared in Examples or Comparative Examples was applied to a washed 10 cm* 10 cm glass substrate to a certain thickness using a spin coater, and then some of the solvent was removed using vacuum chamber dry (VCD) to form a coating film. The photosensitive composition is coated to a coating thickness of 11*µ*m to 13*µ*m after VCD to form a film.

### (2) Prebaking step

In order to remove the solvent contained in the obtained coating film, the film is heated on a hot plate at 100°C to 140°C for 50 seconds to 200 seconds. A certain amount of the solvent in the relevant process may be removed, thereby obtaining a coating film of constant thickness even in the development step after the next process (exposure).

### (3) Exposure step

In order to obtain a certain thickness required for the obtained coating film, a pattern can be formed by irradiating a light source of a metal or LED lamp with an active line of 190 nm to 600 nm, preferably a ghi-line, using an exposure machine. The exposure amount irradiated is 50 to 500 mJ/cm², and the pattern formed is a positive type 9 cm*1 cm strap-shaped pattern.

### (4) Development step

Following the above exposure step, after development is performed by the puddle method in which a certain amount of the substrate is wetted with 2.38 wt% of tetramethylammonium hydroxide (TMAH) as a developer at 23 ± 2°C and developed by waiting for a certain time (minutes), when it is washed with (DI water), the exposed portion is dissolved and removed and only the non-exposed portion remains to form an image pattern, and the thickness of the remaining coating film is 9.0 to 11.0 *µ*m.

### (5) Post-heat treatment step

In order to obtain the image pattern obtained by the above development, the coating film obtained by performing post baking in an oven at 300 to 320°C for 30 to 120 minutes is cured.

### (6) Specimen peeling

In order to obtain a UTM specimen without damage from the substrate that has completed the post-heat treatment step, after the substrate was dipped in a 2% hydrofluoric acid aqueous solution at 23 ± 2°C for a certain period of time (minutes), and then the separated specimen was washed with ultrapure water (DI water), it was dried in a vacuum chamber at room temperature to obtain a specimen for UTM.

### (7) UTM measurement

Through the above specimen peeling step, the tensile strengths and elongations of the specimens of Examples and Comparative Examples were measured respectively through UTM specimens by using QM100S, a universal material testing machine from QMESYS. The measurement was performed under measurement conditions of a measurement temperature of 25°C, a tensile speed of 5 mm/min, and a gauge length of 20 mm.

### (8) Measurement of NMP content

In addition, in order to analyze the NMP contents of the compositions prepared above, the compositions were requested for headspace GC/MS analysis by SGS Korea, a certified certification testing company, and the NMP contents were measured, and the LDL was 5 ppm.

**[Table 3]**

| | **Residues after development** | **Resolution (µm)** | **Elongation (%)** | **Tensile strength (MPa)** | **NMP Content (PPM)** |
|---|---|---|---|---|---|
| **Example 1** | X | 5 | 56.8±0.2 | 140 | N.D |
| **Example 2** | X | 5 | 56.4±0.3 | 138 | N.D |
| **Example 3** | X | 6 | 57.0±0.3 | 142 | N.D |
| **Example 4** | X | 6 | 57.1±0.4 | 142 | N.D |
| **Comparative Example 3** | O | 10 | 46.9±0.3 | 130 | 150 |
| **Comparative Example 4** | O | 12 | 43.8±0.4 | 134 | 158 |

As results of the development test shown in Table 2, it was confirmed that no residue remaining phenomena occurred after development in all of Examples 1 to 4 except for Comparative Examples. In addition, when comparing Example 1 and Comparative Example 3, and Example 4 and Comparative Example 4, which were synthesized with the same composition but with different solvents only, the elongation of Examples 1 and Example 4 were measured to be higher as 10% or more, and the tensile strengths thereof were measured to be higher as 10 MPa or more, thereby confirming that the physical properties of the Examples with a low unreacted monomer content were better. In addition, it was confirmed that the pattern was implemented with excellent resolution compared to the Comparative Examples. As results of analyzing the NMP contents, it was confirmed that no NMP was detected in all of Examples 1 to 4, and that 150 ppm and 158 ppm of NMP were detected in Comparative Examples 1 to 2, respectively. Recently, regulations have been increasing to remove NMP, which is harmful to the human body, or prevent it from being used in display and semiconductor materials, and it is possible to prepare a composition that does not contain NMP using the synthesis method proposed in this patent.

The present disclosure is not limited to the above Examples and may be prepared in various different forms.

The above description is merely illustrative of the present disclosure, and those skilled in the art to which the present disclosure pertains will be able to make various modifications without departing from the essential characteristics of the present disclosure.

Accordingly, the embodiments disclosed in this specification are for illustrative purposes only and are not intended to limit the present disclosure, and the spirit and scope of the present disclosure are not limited by these embodiments. The scope of protection of the present disclosure should be interpreted in accordance with the claims, and all technologies within the scope equivalent thereto should be interpreted as being included in the scope of rights of the present disclosure.

## Claims

1. A method for producing a polymer produced using γ-butyrolactone as a single solvent by including the following Formula 1-1; Formula 1-2; Formula 1-3; Formula 1-4; or combinations thereof. 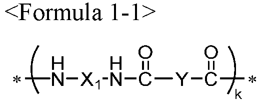 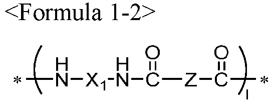 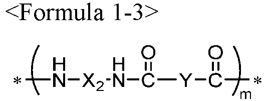 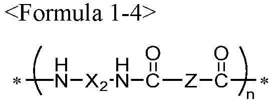
In Formula 1-1; Formula 1-2; Formula 1-3; and Formula 1-4 above,
1) * is a part where the bonds are connected as repeating units,
2) * at the end of the polymer is a part where Formulas Q-1 to Q-10 are bonded by an amide bond or imide bond,
3) X₁ or X₂ is Formula 2 below,
4) Y is selected from the group consisting of: a C₆ to C₃₀ arylene group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkylene group; a C₁ to C₂₀ cycloalkylene group; a C₂ to C₂₀ alkenylene group; a C₃ to C₂₀ cycloalkenylene group; a C₂ to C₂₀ alkynylene group; a C₃ to C₂₀ cycloalkynylene group; Formula 2; or combinations thereof,
5) Z is selected from the group consisting of: a C₆ to C₃₀ arylene group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkylene group; a C₁ to C₂₀ cycloalkylene group; a C₂ to C₂₀ alkenylene group; a C₃ to C₂₀ cycloalkenylene group; a C₂ to C₂₀ alkynylene group; a C₃ to C₂₀ cycloalkynylene group; Formula 3; or combinations thereof,
6) k, l, m, and n are integers of 1 or more, 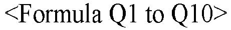 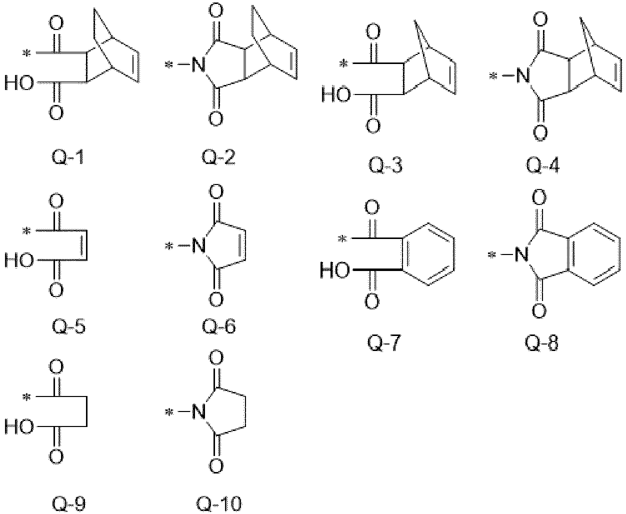
7) The polymer terminal is one in which a formula selected from the group consisting of one selected from the Formulas Q-1 to Q-10 above or combinations thereof is bonded by an amide or imide bond, 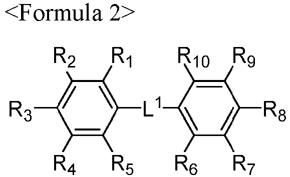
In Formula 2,
8) L¹ is selected from the group consisting of a single bond, -CH₂-, -CH₂CH₂-,-CH₂OCH₂-, -CH(CH₃)-, -C(CH₃)₂-, -C(C₂H₅)₂-, -C(C₃H₇)₂-, -C(C₄H₉)₂-, -C(C₅H₁₁)₂-, -C(C₆H₁₃)₂-, -C(C₅H₁₀)-, -O-, -CH(CF₃)-, -C(CF₃)₂-, -S-, -SO₂-, Si(CH₃)₂-, -C₆H₄-, -CO-, -NHCO-, and -COO-,
9) Two of R₁ to R₁₀ are connection sites with amide groups of Formulas 1-1 and 1-2,
10) Residual R₁ to R₁₀ except for the above connection sites are each independently hydrogen; heavy hydrogen; a hydroxyl group; an C₆ to C₃₀ aryl group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkyl group; a C₂ to C₂₀ alkenyl group; a C₂ to C₂₀ alkyne group; a C₁ to C₂₀ alkoxy group; a C₆ to C₃₀ aryloxy group; a fluorenyl group; a carbonyl group; an ether group; a carboxyl group; or a C₁ to C₂₀ alkoxycarbonyl group,
11) When L¹ is a single bond, adjacent R₁ and R₁₀ which are not the connection sites; and R₅ and R₆ may form a ring, 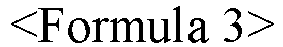 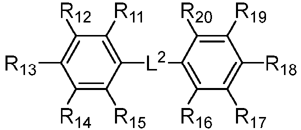
In Formula 3,
12) L² is selected from the group consisting of a single bond, -CH₂-, -CH₂CH₂-,-CH₂OCH₂-, -CH(CH₃)-, -C(CH₃)₂-, -C(C₂H₅)₂-, -C(C₃H₇)₂-, -C(C₄H₉)₂-, -C(C₅H₁₁)₂-, -C(C₆H₁₃)₂-, -C(C₅H₁₀)-, -O-, -CH(CF₃)-, -C(CF₃)₂-, -S-, -SO₂-, Si(CH₃)₂-, -C₆H₄-, -CO-, -NHCO-, and -COO-,
13) Two of R₁₁ to R₂₀ are connection sites with amide groups of Formulas 1-1 and 1-2,
14) Residual R₁₁ to R₂₀ except for the above connection sites are each independently hydrogen; heavy hydrogen; a hydroxyl group; an C₆ to C₃₀ aryl group; a C₂ to C₃₀ heterocyclic group containing at least one heteroatom among O, N, S, Si, and P; a fused ring group of C₆ to C₃₀ aliphatic ring and aromatic ring; a C₁ to C₂₀ alkyl group; a C₂ to C₂₀ alkenyl group; a C₂ to C₂₀ alkyne group; a C₁ to C₂₀ alkoxy group; a C₆ to C₃₀ aryloxy group; a fluorenyl group; a carbonyl group; an ether group; a carboxyl group; or a C₁ to C₂₀ alkoxycarbonyl group, and provided that two of residual R₁₁ to R₂₀ except for the above connection sites are carboxyl groups, and
15) When L² is a single bond, adjacent R₁₁ and R₂₀ which are not the above connection sites; and R₁₅ and R₁₆ may form a ring.

2. The method for producing a polymer of claim 1, wherein the polymer produced by the above production method has a yield of 80% or more.

3. The method for producing a polymer of claim 1 or 2, wherein it is produced by further comprising pyridine.

4. The method for producing a polymer of any one of claims 1 to 3, wherein the polymer is prepared from a diamine monomer; a diacyl chloride monomer; an anhydride monomer; and a combination thereof.

5. The method for producing a polymer of claim 4, wherein the diamine includes one or more monomers selected from the group consisting of 2,2'-bis (3-amino-4-hydroxyphenyl) hexafluoropropane, 2,2'-bis (3-amino-4-hydroxyphenyl)propane, 3,3'-dihydroxybenzidine, 4,4'-methylenebis(2-aminophenol), 4,4'-(cyclohexane-1,1-diyl)bis(2-aminophenol), 4,4'-(pentane-3,3-diyl)bis(2-aminophenol), 4,4'-(heptane-4,4-diyl)bis(2-aminophenol), 4,4'-(nonane-5,5-diyl)bis(2-aminophenol), 4,4'-(4-methylpentane-2,2-diyl)bis(2-aminophenol), 4,4'-(bis(trimethylsilyl)methylene)bis(2-aminophenol), or combinations thereof.

6. The method for producing a polymer of claim 4 or 5, wherein the diacyl chloride includes one or more monomers selected from the group consisting of 4,4'-oxybisbenzoyl chloride, 1,2-cyclobutanedicarboxylic acid dichloride, terephthaloyl chloride, isophthaloyl chloride, 4,4'-biphenyldicarbonyl chloride, 1,4-naphthalenedicarbonyl chloride, 4,4'-sulfonyldibenzoyl chloride, 1,4-cyclohexanedicarboxylic acid dichloride, or combinations thereof.

7. The method for producing a polymer of any one of claims 4 to 6, wherein the anhydride includes one or more monomers selected from the group consisting of bicyclo[2.2.2]oct-5-ene-2,3-dicarboxylic anhydride, 5-norbornene-2,3-dicarboxylic anhydride, maleic anhydride, phthalic anhydride, succinic anhydride, or combinations thereof.

8. A positive photosensitive composition comprising: the polymer of any one of the preceding claims; a photosensitizer; a solvent; and an additive.

9. The positive photosensitive composition of claim 8, wherein the photosensitizer includes one or more of the following Formulas P-1 to P-8: 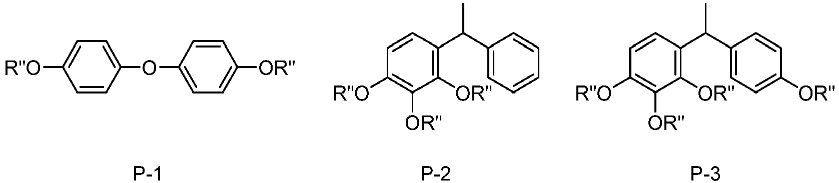 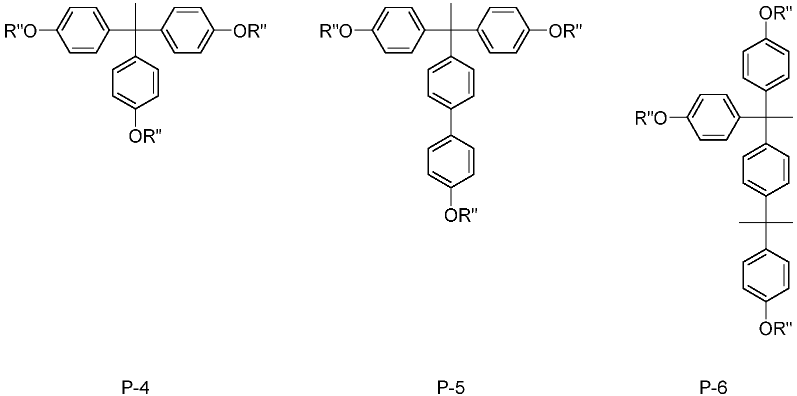 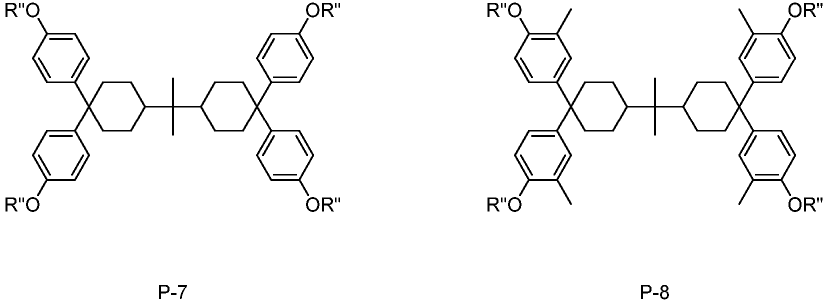 In P-1 to P-8, R" is hydrogen; Formula S-1 below; or Formula S-2 below.

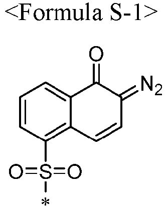

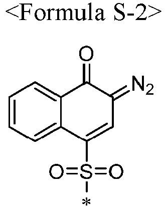

10. The positive photosensitive composition of claim 8 or 9, wherein the solvent includes one or more selected from the group consisting of N,N-dimethylformamide, N-methylformanilide, N-methylacetamide, N,N-dimethylacetamide, dimethyl sulfoxide, benzyl ethyl ether, dihexyl ether, acetyl acetone, gamma-butyrolactone, diethylene glycol monomethyl ether, diethylene glycol monoethyl ether, diethylene glycol dimethyl ether, diethylene glycol methyl ethyl ether, diethylene glycol diethyl ether, propylene glycol methyl ether acetate, propylene glycol propyl ether acetate, or combinations thereof.

11. The positive photosensitive composition of any one of claims 8 to 10, wherein the additive includes one or more selected from the group consisting of a silane-based coupling agent; a surface leveling agent; a surfactant; a crosslinking agent; or combinations thereof.

12. A pattern or film manufactured from the positive photosensitive composition of any one of claims 8 to 11 at 300 to 400°C.

13. A semiconductor device manufactured using the pattern or film of claim 12.

14. A display device manufactured using the pattern or film of claim 12.
